Europäisches Patentamt

European Patent Office

Office européen des brevets

(19)

(11) Veröffentlichungsnummer: **0 208 267**
**B1**

(12) ## EUROPÄISCHE PATENTSCHRIFT

(45) Veröffentlichungstag der Patentschrift:
07.03.90

(21) Anmeldenummer: 86109083.5

(22) Anmeldetag: 03.07.86

(51) Int. Cl.⁴: **H01L 27/10**, H01L 21/40, H01L 23/52

(54) **Verfahren zum Herstellen von Kreuzkopplungen zwischen n- und p-Kanal-CMOS-Feldeffekt-Transistoren von statischen Schreib-Lese-Speichern, insbesondere bei 6-Transistor-Speicherzellen-Anordnungen.**

(30) Priorität: 05.07.85 DE 3524202

(43) Veröffentlichungstag der Anmeldung:
14.01.87 Patentblatt 87/3

(45) Bekanntmachung des Hinweises auf die Patenterteilung:
07.03.90 Patentblatt 90/10

(84) Benannte Vertragsstaaten:
AT DE FR GB IT NL

(56) Entgegenhaltungen:
EP-A- 0 097 595
FR-A- 2 219 493
GB-A- 2 141 871
US-A- 4 246 593
US-A- 4 370 798
US-A- 4 408 385

IBM TECHNICAL DISCLOSURE BULLETIN, Band 23,
Nr. 8, Januar 1981, Seiten 3683-3686, New York, US; A.S.
BARAN et al.: "Static RAM double polysilicon process"

(73) Patentinhaber: Siemens Aktiengesellschaft,
Wittelsbacherplatz 2, D-8000 München 2(DE)

(72) Erfinder: Neppl, Franz, Dr., St. Quirin-Platz 6,
D-8000 München 90(DE)
Erfinder: Hieber, Konrad, Dr., Laubensteinstrasse 7,
D-8214 Bernau(DE)
Erfinder: Schwabe, Ulrich, Dr., Klausener Platz 24,
D-8000 München 90(DE)

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

**Beschreibung**

Die Erfindung betrifft ein Verfahren zum Herstellen von Kreuzkopplungen zwischen n- und p-Kanal-CMOS-Feldeffekt-Transistoren von statischen Schreib-Lese-Speichern (SRAMs), bei dem nach bekannten Verfahrensschritten der CMOS-Technologie (= Herstellung von komplementären CMOS-Transistoren) vergrabene Kontakte (buried contacts) zu den diffuntierten n⁺ - und p⁺ -Bereichen der Transistoren im Substrat erzeugt werden und bei dem die aus dotiertem Polysilizium und Metallsilizid bestehende Gate-Ebene als zusätzliche Verdrahtungsebene für die Kreuzkopplung zwischen n- und p-Kanaltransistoren verwendet wird, sowie die Verwendung dieses Verfahrens zur Herstellung einer statischen 6-Transistor-Speicherzellen-Anordnung.

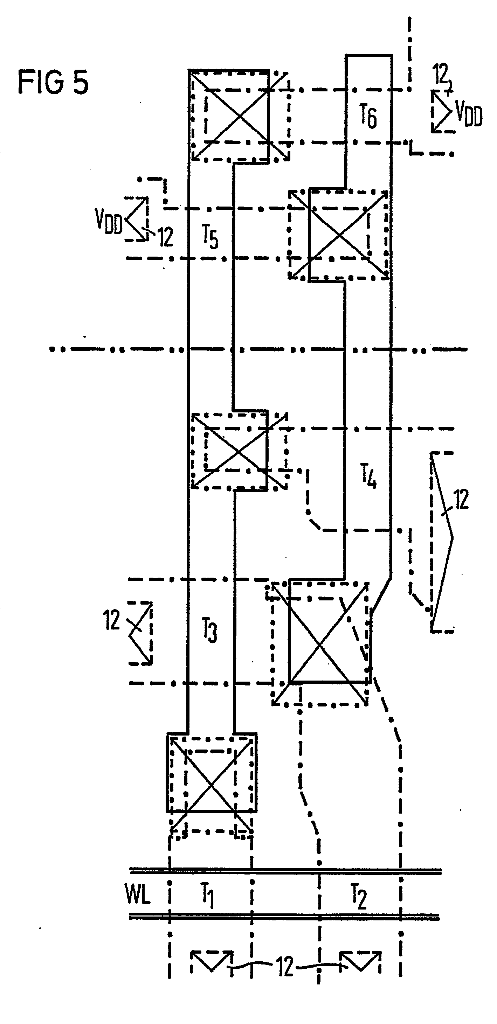

Die Wirkungsweise einer statischen 6-Transistor-Speicherzelle sowie ihr Aufbau ist beispielsweise aus dem Buch "Semiconductor Memory Design and Application" von Lücke, Mize, Carr, Mc Graw Hill, Kogakusha Ltd, Fig. 5.3, Seite 118, zu entnehmen. Ein Nachteil dieser Zelle ist gegenüber der dynamischen 1-Transistorzelle, auch wegen der benötigten Kreuzkopplungen, der große Platzbedarf.

Insbesondere bei den CMOS-SRAM-Zellen sind die Kreuzkopplungen zwischen n- und p-Kanaltransistoren problematisch. In bekannten CMOS-Technologien mit Gate aus n⁺-dotiertem Polysilizium oder aus n⁺ - dotierten Doppelschichten aus Polysilizium und Metallsilizid sind vergrabene Kontakte (sogenannte buried contacts) gleichzeitig zu n⁺ -dotierten und p⁺ -dotierten Gebieten nicht möglich. Die Kreuzverbindungen müssen über zusätzliche Metallbrücken hergestellt werden. Dadurch werden zusätzliche Metallraster pro Zelle benötigt, welche die Packungsdichte erheblich beeinträchtigen.

Eine Verkleinerung der statischen RAM-Zellen wird durch die Verwendung zustätzlicher Verdrahtungsebenen, die zum Beispiel aus Polysilizium oder Aluminium bestehen, ermöglicht, wobei pro Verdrahtungsebene jeweils zwei Verfahrensschritte der Fotolithographie und des Ätzens anfallen. Die Realisierung von sogenannten "buried contacts" zu n⁺ - und p⁺ -Gebieten erlaubt es, die Gate-Ebene für die benötigten Kreuzkopplungen zu benützen. Dadurch kann eine Zusatzverdrahtungsebene eingespart, oder, bei konstanter Zahl von Verdrahtungsebenen, die Packungsdichte erhöht werden.

Ein solches Verfahren, wie auch eingangs erwähnt, wird in einem Bericht von Kudoh et. al. im IEDM Technical Digest 1984 auf den Seiten 67-70 angegeben. Es basiert auf dem schwierig zu kontrollierenden Prozeß der selektiven Silizierung und enthält maskenaufwendige Schritte zur lokalen n⁺ - bzw. p⁺ -Dotierung der Polysiliziumbereiche vor der Silizierung.

Aufgabe der Erfindung ist es, ein einfaches und wenig maskenaufwendiges Verfahren anzugeben, mit dem es möglich ist, nach der CMOS-Technologie statische Schreib-Lese-Speicher-Anordnungen mit verringertem Platzbedarf herzustellen. Dabei soll die Gate-Ebene für die benötigten Kreuzkopplungen ausgenützt werden. Insbesondere soll aber durch das Verfahren die Herstellung einer 6-Transistor-SRAM-Zelle mit hoher Packungsdichte in einem Speicherbaustein ermöglicht werden.

Die erfindungsgemäße Aufgabe wird durch ein Verfahren der eingangs genannten Art dadurch gelöst, daß die Gate-Ebene nach der Öffnung der Bereiche für die vergrabenen Kontakte durch Abscheiden einer Doppelschicht, bestehend aus undotiertem Polysilizium und Metallsilizid und Strukturierung der Gate-Elektroden und der Kreuz-Kopplungen gebildet wird und daß die Dotierung der Polysiziumbereiche und der n⁺ - und p⁺ -Bereiche im Substrat gleichzeitig mit der Erzeugung der Source/Drain-Bereiche des jeweiligen Transistortyps durch maskierte Ionen-Implantation und nachfolgende Hochtemperaturbehandlung durchgeführt wird.

Durch das Verfahren nach der Lehre der Erfindung, welches sich in einzelnen Prozeßschritten der CMOS-Technologie weitgehend an das in der deutschen Patentanmeldung P 34 19 034.1 vorgeschlagene Verfahren anlehnt, werden mit nur einer zusätzlichen Fototechnik bei der Herstellung der Kontaktlochätzung für die buried contacts statische RAM-Zellen hoher Packungsdichte mit "buried contacts" zu n⁺ - und p⁺ - Gebieten erhalten.

Weitere Ausgestaltungen der Erfindung ergeben sich aus den Unteransprüchen.

Ein Verfahren zur Realisierung einer 6-Transistor-CMOS-SRAM-Zelle nach der Lehre der Erfindung wird nachfolgend anhand der Figuren 1 bis 5 noch näher beschrieben. Dabei zeigen

die Figuren 1 bis 4 im Schnittbild die erfindungswesentlichen Verfahrensschritte, wobei nur zwei Transistorbereiche und eine Kreuzkopplung (Bereich C) sichtbar sind;
die Figur 5 zeigt das vollständige Layout einer so hergestellten Zelle.

Es gelten in allen Figuren für gleiche Teile gleiche Bezugszeichen.

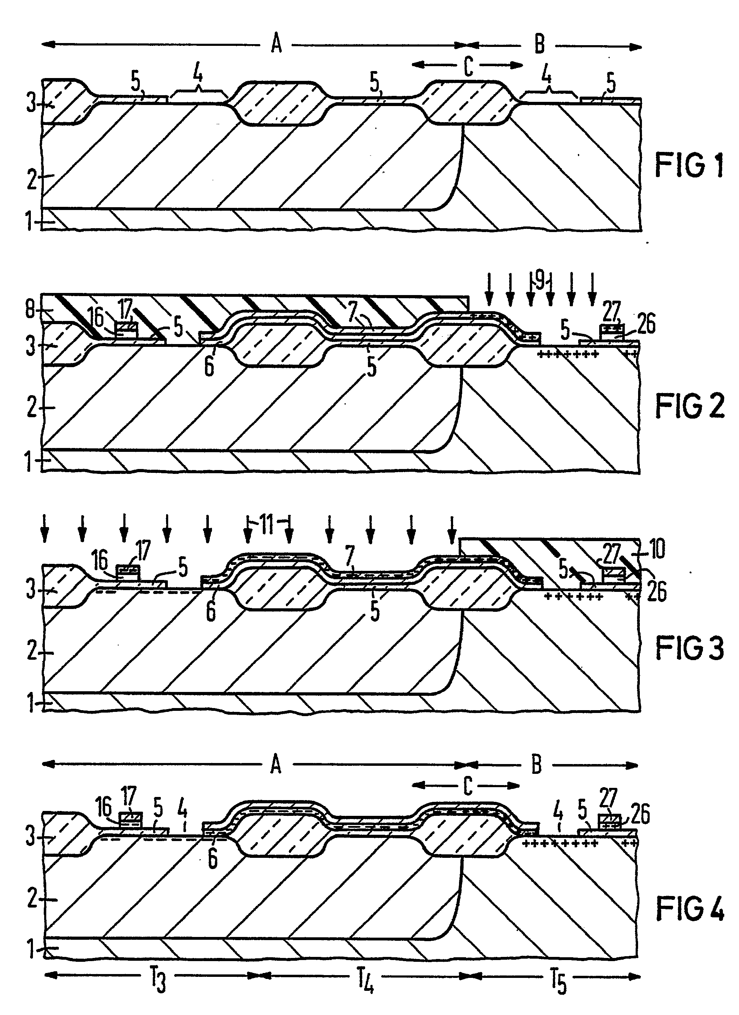

Figur 1: In einem n-dotierten Siliziumsubstrat 1 werden nach bekannten Verfahrensschritten der CMOS-Technologie p-dotierte Wannen 2 erzeugt und zur Trennung der aktiven Transistorbereiche strukturierte SiO₂ -Schichten 3 nach dem sogenannten LOCOS (= local oxidation of silicon) -Verfahren hergestellt. Dabei betrifft der Bereich A die n-Kanal-CMOS-Feldeffekt-Transistoren und der Bereich B die p-Kanal-CMOS-Feldeffekt-Transistoren. Im Bereich C liegt die Kreuzkopplung. Die mit dem Bezugszeichen 4 bezeichneten Oberflächenbereiche zeigen die in der Gateoxidschicht 5 durch Fotolithographie geöffneten Kontaktlöcher für die "buried contacts" an.

Figur 2: Es erfolgt nun die ganzflächige Abscheidung einer Doppelschicht, bestehend aus undotiertem Polysilizium 6 und - nach ausreichender Reinigung - von Tantaldisilizid 7 und Strukturierung dieser Doppelschicht 6,7 zur Definition der Gate-Elektroden 16/17 und 26/27, sowie der Kreuzkopplung C. Da das Polysilizium undotiert ist, können die beiden Schichten hintereinander ohne Belüftung in der gleichen Anlage abgeschieden werden. Die mittels Fotolack 8 maskierte Source/Drain-Implantation 9 für die p-Kanal-Transistoren B erfolgt mit Bor in bekannter Weise (Dosis und Energie $5\times10^{15}cm^2$ und 25 keV). Dabei wird gleichzeitig Bor (+) in das Tantaldisilizid 27 der p-Kanal-Transistoren und in das Tantaldisilizid 7 eines Teiles der Kreuzkopplung C implantiert.

Figur 3: Nach Ablösen der Fotolackstruktur 8 wird eine weitere Fotolackstruktur 10, welche die Bereiche der p-Kanaltransistoren B im n-Substrat 1 bedeckt, aufgebracht und eine Arsen- oder Phosphor-Ionen-Implantation 11 (Dosis und Energie $5\times10^{15}$ cm$^{-2}$ und 80 keV) zur Erzeugung der Source/DrainBereiche für die n-Kanal-Transistoren A durchgeführt. Dabei wird gleichzeitig Arsen oder Phosphor (-) in das Tantaldisilizid (17) der n-Kanal-Transistoren und in das Tantaldi-silizid 7 des anderen Teils der Kreuzkopplung C implantiert. Der besseren Übersicht wegen sind die Source/ Drain-Bereiche in den Figuren nicht eingezeichnet worden.

Figur 4: Zur Erzeugung der Source/Drain-Bereiche der Transistoren im Siliziumsubstrat 1 bzw. in der p-Wanne 2 und zur Ausdiffusion des jeweiligen Dotierstoffes (+ und -) aus dem Tantaldisilizid 7, 17, 27 in das Polysilizium 6, 16, 26 (n+ /p+ -Polyzid-Gate) und im Bereich der "buried contacts" (4) erfolgt nun nach Entfernung der Fotolackstruktur 10 eine Hochtemperaturbehandlung in Stickstoff/Wasserstoff-Atmosphäre. Dabei werden bei 900° C (ca. 60 Minuten) die implantierten Bor (+)-und Arsen (-)-Ionen in die darunterliegenden Bereiche eingetrieben. Die Fertigstellung der Anordnung bis zur Endmetallisierung erfolgt in gewohnter Weise. Die Symbole $T_3$, $T_4$, $T_5$ stehen für die Bereiche von drei Transistoren einer 6-Transistorzelle.

Figur 5 zeigt das Layout einer nach dem erfindungsgemäßen Verfahren hergestellten 6-Transistor-SRAM-Zelle. Ihr Platzbedarf beträgt 37 μm × 12,8 μm = 474 μm$^2$. Es gelten die gleichen Bezugszeichen wie in Figur 4. $V_{DD}$ zeigt die Anschlüsse für die Versorgungsspannung an. Mit $T_1$ bis $T_6$ sind die MOS-Feldeffekt-Transistorbereiche bezeichnet. Die durchgezogene Linie umschreibt die Gatemetallisierung (7, 17, 27), die gestrichelte Linie die Kontaktlochbereiche 12 aus der Metallebene, die strich-punktierte Linie die "buried contacts" (4) und die strich-strich- punktierte Linie die Kante der Feldoxidbereiche (LOCOS). Die punkt-punktstrichlierte Linie trennt den p-Wannenbereich im ndotierten Substrat ab. Die doppelt eingezeichnete Linie markiert die Wortleitung WL.

Wie aus der Figur 5 zu entnehmen ist, verläuft eine Kreuzkopplung C von dem Gate $T_4$ der n-Kanal-Transistoren auf den Source- bzw. Drain-Bereich $T_5$ der p-Kanaltransistoren und von dem Gate des Transistors $T_5$ auf den Source-Drain-Bereich $T_4$ der n-Kanal-Transistoren.

Ein Schaltbild zum Betrieb dieser Anordnung ist dem in der Beschreibungseinleitung genannten Buch von Lücke zu entnehmen.

## Patentansprüche

1. Verfahren zum Herstellen von Kreuzkopplungen (C) zwischen n- und p-Kanal-CMOS-Feldeffekt-Transistoren (A, B) von statischen Schreib-Lese-Speichern (SRAMs), bei dem nach bekannten Verfahrensschritten der CMOS-Technologie vergrabene Kontakte zu den diffundierten n;s+ - und p;s+ - Bereichen der Transistoren im Substrat (1,2) erzeugt werden und bei dem die aus dotiertem Polysilizium (6, 16, 26) und Metallsilizid (7, 17, 27) bestehende Gate-Ebene als zusätzliche Verdrahtungsebene für die Kreuzkopplung (C) zwischen n- und p-Kanaltransistoren (A, B) verwendet wird, **dadurch gekennzeichnet**, daß die Gate-Ebene (6, 7, 16, 17, 26, 27) nach der Öffnung der Bereiche (4) für die vergrabenen Kontakte durch Abscheiden einer Doppelschicht, bestehend aus undotiertem Polysilizium (6) und Metallsilizid (7), und Strukturierung der Gate-Elektroden (16, 17, 26, 27) und der Kreuzkopplungen (C) gebildet wird und daß die Dotierung der Polysiliziumbereiche (6, 16, 26) und der n;s+ - und p;s+ -Bereiche im Substrat (1, 2) gleichzeitig mit der Erzeugung der Source/Drain-Bereiche des jeweiligen Transistortyps (A, B) durch maskierte (8, 10) Ionen-Implantation (9, 11) und nachfolgende Hochtemperaturbehandlung durchgeführt wird.

2. Verfahren nach Anspruch 1, **dadurch gekennzeichnet**, daß die aus undotiertem Polysilizium (6) und vorzugsweise Tantaldisilizid (7) bestehende Doppelschicht durch Aufdampfen, Aufstäuben oder durch chemische Dampfabscheidung (CVD) hergestellt wird.

3. Verfahren nach Anspruch 1 oder 2, **dadurch gekennzeichnet**, daß für die Ionenimplantationen (9, 11) die Dotierstoffe Bor und Arsen oder Phosphor verwendet werden.

4. Verfahren nach mindestens einen der Ansprüchen 1 bis 3, **dadurch gekennzeichnet**, daß die Temperaturbehandlung im Bereich von 900°C bis 950°C mit einer Zeitdauer von ca. 60 Minuten durchgeführt wird.

5. Verwendung des Verfahrens nach mindestens einem der Ansprüche 1 bis 4 zur Herstellung einer statischen 6-Transistor-Speicherzellen-Anordnung.

## Claims

1. Method of producing cross-couplings (C) between n- and p-channel CMOS field-effect transistors (A, B) of static read-write memories (SRAMs), in which according to known processing steps of CMOS ·technology, buried contacts to the diffused n+- and p+-regions of the transistors are produced in the substrate (1, 2) and in which the gate level consisting of doped polysilicon (6, 16, 26) and metal silicide (7, 17, 27) is used as an additional wiring level for the cross-coupling (C) between n- and p-channel transistors (A, B), characterized in that the gate level (6, 7, 16, 17, 26, 27) is formed after the opening of the regions (4) for the buried contacts by depositing a double layer consisting of undoped polysilicon (6) and metal silicide (7), and after structuring of the gate electrodes (16, 17, 26, 27) and of the cross-couplings (C) and in that the doping of the polysilicon regions (6, 16, 26) and of the n+- and p+- regions in the substrate (1, 2) is carried out simultaneously with the production of the source-drain regions of the respective transistor type (A, B) by masked (8, 10) ion implantation (9, 11) and subsequent high-temperature treatment.

2. Method according to Claim 1, characterized in that the double layer consisting of undoped polysilicon (6) and preferably tantalum disilicide (7) is produced by vapour evaporation, sputtering or by chemical vapour deposition (CVD).

3. Method according to Claim 1 or 2, characterized in that, for the ion implantations (9, 11) the doping materials boron and arsenic or phosphorus are used.

4. Method according to at least one of Claims 1 to 3, characterized in that the temperature treatment is carried out in the range from 900°C to 950°C with a duration of approximately 60 minutes.

5. Use of the method according to at least one of Claims 1 to 4 for the production of a static 6-transistor memory cell arrangement.

**Revendications**

1. Procédé pour fabriquer des couplages croisés (C) entre des transistors à effet de champ CMOS à canal n et p (A, B) de mémoires statiques d'enregistrement-lecture (SRAM), et selon lequel on forme, conformément à des étapes opératoires connues de la technologie CMOS, des contacts ensevelis atteignant les zones de type n+ et p+ diffusées des transistors dans le substrat (1, 2), et on utilise le plan des grilles, constitué par du polysilicium dopé (6, 16, 26) et un siliciure métallique (7, 17, 27), et tant que plan supplémentaire de câblage pour le couplage croisé (C) entre les transistors à canal n et p (A, B), caractérisé par le fait qu'on forme le plan des grilles (6, 7, 16, 17, 26, 27), après avoir ouvert les régions (4) pour les contacts ensevelis, au moyen du dépôt d'une couche double formée de polysilicium non dopé (6) et d'un siliciure métallique (7), structuration des électrodes de grille (16, 17, 26, 27) et des couplages croisés (C), et qu'on réalise le dopage des régions en polysilicium (6, 16, 26) et des régions de type n+ et p+ dans le substrat (1, 2) en même temps que la formation des régions de source/drain du type respectif de transistor (A, B) au moyen d'une implantation ionique (9, 11) avec masquage (8, 10) et d'un traitement ultérieur à une température élevée.

2. Procédé suivant la revendication 1, caractérisé par le fait qu'on fabrique la couche double constituée par du polysilicium non dopé (6) et de préférence du disiliciure de tantale (7), par dépôt par évaporation, pulvérisation ou dépôt chimique en phase vapeur (CVD).

3. Procédé suivant la revendication 1 ou 2, caractérisé par le fait que pour les implantations ioniques (9, 11), on utilise comme substances dopantes le bore et l'arsenic ou le phosphore.

4. Procédé suivant au moins l'une des revendications 1 à 3, caractérisé par le fait qu'on exécute le traitement thermique à une température située dans la plage de 900°C à 950°C, pendant une durée d'environ 60 minutes.

5. Application du procédé suivant au moins l'une des revendications 1 à 4 pour fabriquer un dispositif à cellules de mémoire statiques à 6 transistors.

**FIG 1**

**FIG 2**

**FIG 3**

**FIG 4**

FIG 5